Europäisches Patentamt

European Patent Office

Office européen des brevets

(11) Publication number: **0 090 237**
**B1**

(12) **EUROPEAN PATENT SPECIFICATION**

(45) Date of publication of patent specification: **04.02.87**

(21) Application number: **83102474.0**

(22) Date of filing: **14.03.83**

(51) Int. Cl.⁴: **H 02 M 3/155**

(54) Electronic voltage control device.

(30) Priority: **30.03.82 IT 2048082**

(43) Date of publication of application:
**05.10.83 Bulletin 83/40**

(45) Publication of the grant of the patent:
**04.02.87 Bulletin 87/06**

(84) Designated Contracting States:
**BE DE FR GB NL SE**

(56) References cited:
**EP-A-0 018 343**

**IEEE TRANSACTIONS ON AEROPSPACE AND ELECTRONIC SYSTEMS, vol. AES-12, no. 6, November 1976, pages 706-717, New York, US. W. W. BURNS et al.: "State trajectories used to observe and control DC-to-DC converters"**

(73) Proprietor: **FIAR S.p.A.**
**Via G.B. Grassi, 93**
**I-20157 Milano (IT)**

(72) Inventor: **Di Cesare, Domenico**
**Via Giro Esterno Nord, 143**
**I-71017 Torremaggiore (Foggia) (IT)**

(74) Representative: **Modiano, Guido et al**
**MODIANO, JOSIF, PISANTY & STAUB Modiano & Associati Via Meravigli, 16**
**I-20123 Milan (IT)**

Courier Press, Leamington Spa, England.

## Description

This invention relates to an electronic voltage control device.

Known and commercially available are devices for controlling the voltage across a load, wherein an electric circuit, to which a non-constant input DC voltage is applied, delivers a regulated output DC voltage. In particular, known is a circuit comprising an active element controlled by a hysteresis comparator, an output filter, and an inductor which is operative to control the input average current. That circuit has a transfer function of the first order, the single pole whereof is only provided by the capacitor of the output filter. Consequently, the circuit operates as a driven current source feeding the load. The advantage of said circuit over other conventional ones is that it is quite stable, on account of its transfer function of the first order.

However, said prior device has the disadvantage that it is not possible to adjust thereby the switch-over rate of the active element.

Several attempts have been made by the applicant to solve this problem, e.g. by sending synchronization pulses to the input of the hysteresis comparator to cause it to switch over at preset moments in time. A circuit implementing this solution is shown in EP—A—18343. However, this solution has failed to prove adequate because the behavior of frequency versus input voltage (as shown in Figure 12) is parabolic, thereby a complicated synchronization circuit is required which can discriminate whether the voltage is higher or lower than one half of the output voltage, and hence supply pulses with a different sign.

Moreover, even in this case, there would be left an indecision range on either sides of the peak value, whereby the circuit is no longer fully reliable. Another disadvantage of this solution is that the inductive impedance present in the regulating circuit begins to make itself felt, so that the transfer function of the system becomes of the second order and the desired stability feature is lost.

Accordingly, the task of the invention is to provide an electronic voltage control device which, while having a transfer function of the first order, is also effective to afford the possibility of controlling or adjusting the switch-over rate of the active element.

Within that task it is a primary object of the invention to provide such an electronic voltage control device of high reliable operation, and, in particular, effective to be easily synchronized.

It is a further object of the invention to provide such a control device, which can be made by using integrated and solid state power components of low cost and readily available on the market.

According to one aspect of the invention the above task and objects are achieved by an electronic voltage control device as defined in appended claim 1.

The features and advantages of the invention will be more clearly apparent from the following description of a preferred, though not limitative, embodiment of this device, with reference to the accompanying illustrative drawings, where:

Figure 1 is a schematic circuit diagram of a voltage controller according to a conventional design;

Figures 2 and 3 show two time graphs of electric signals pertaining to the circuit of Figure 1;

Figure 4 is a general block diagram representation of the voltage controller according to the invention;

Figure 5 is a detailed wiring diagram of the inventive voltage controller;

Figures 6 to 11 show time graphs of electric signals pertaining to the circuit of Figure 5; and

Figure 12 illustrates the behavior of frequency versus input voltage of the known current control stage as included in the voltage controller according to the invention.

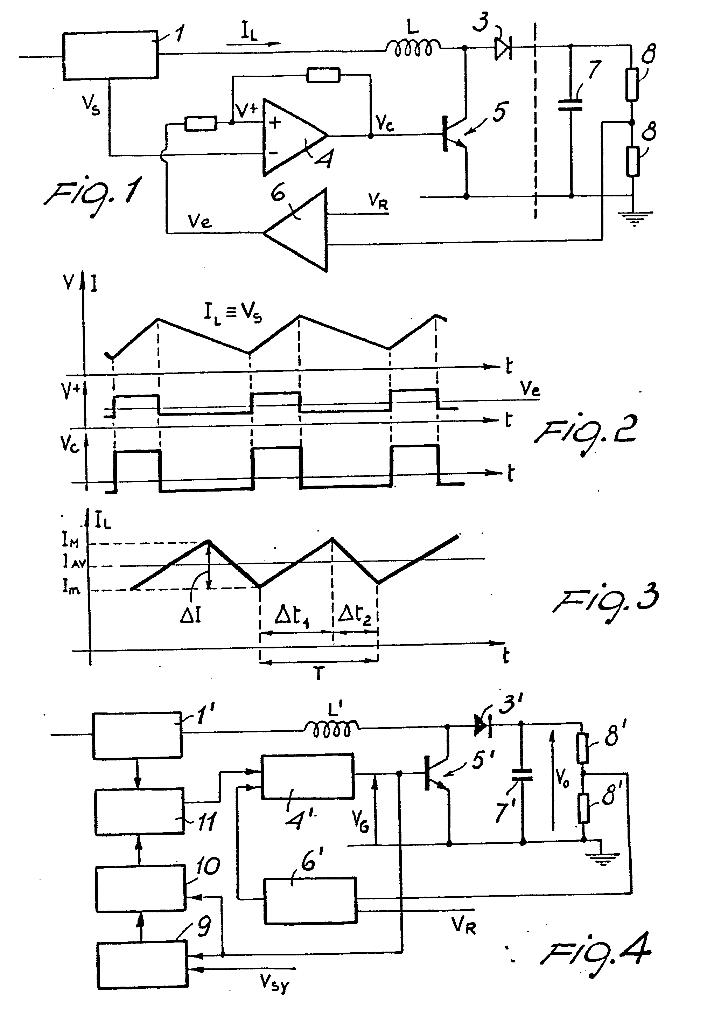

Making reference to Figure 1, there is shown there a circuit diagram of a prior device having a transfer function of the first order. This circuit comprises essentially a current sensor 1, an inductor L located downstream of said sensor, a diode 3, a comparator 4 to the input whereof the signal from said sensor 1 is applied, and an error operational amplifier 6. Downstream of said comparator 4, an active switch-over element (transistor 5) is provided which is controlled by the signal from the comparator 4. The circuit further includes an output filter comprising a capacitor 7 and resistors 8. To one input of the error amplifier 6, there is applied a signal proportional to the output voltage, as taken at the resistors 8 connection point, while to the other input of said amplifier 6 a reference signal $V_R$ is applied, as it is conventional, in such a way that the operational amplifier 6 supplies the hysteresis comparator 4 with a voltage which is proportional to the difference between the two input voltages.

The mode of operation of the above conventional device will be presently discussed herein below. The sensor 1 supplies, to the (−) input of the comparator 4, a voltage Vs which is proportional to the current through the inductance L, which, as shown in Figure 2 and better explained hereinafter, is triangular with a gradient determined by the value of said inductance L. Supplied to the (+) input of the comparator 4 is the error voltage Ve which is proportional to the difference between the load voltage and a reference voltage $V_R$. As Vs increases to Ve, the comparator output is negative and the transistor 5 is switched off, whereas as Vs, on the falling edge, becomes equal to Ve, the comparator output voltage becomes positive and switches on the transistor 5. Thus, the output voltage (Vc) of the comparator is a square wave with a frequency varying with the input voltage. Accordingly, the output voltage is regulated by controlling the transconductance, i.e. the average input current. This circuit does not allow, however, frequency regulation and constant frequency operation.

For a better understanding of the principle of this invention, reference may be had to Figure 3, which shows the current flowing through the inductance L. Given that

$$\Delta t_1 = \frac{\Delta I \times L}{V_{in}}$$

$$\Delta t_2 = \frac{\Delta I \times L}{V_o - V_{in}}$$

$$T = \Delta t_1 + \Delta t_2 = \frac{\Delta I \times L \times V_o}{V_{in}(V_o - V_{in})}$$

and, therefore,

$$f = \frac{1}{T} = \frac{V_{in}(V_o - V_{in})}{\Delta I \times L \times V_o}$$

it being,

$$\Delta I = I_M - I_m$$

the frequency is inversely proportional to the current hysteresis ΔI. Consequently, by regulating the latter, the switch-over rate of the transistor 5 is also regulated.

For the voltage regulation loop not to interact with the frequency control loop, it is necessary that control of the hysteresis current ΔI be effected without the average input current $I_{AV}$ undergoing any change. In that event, the system transfer function would no longer be, in fact, of the first order.

Since

$$I_{AV} = \frac{I_M + I_m}{2}$$

we obtain that

$$I_M = I_{AV} + \frac{\Delta I}{2}$$

$$I_m = I_{AV} - \frac{\Delta I}{2}$$

and therefore, if the average current $I_{AV}$, as controlled by the voltage regulation loop, is added and subtracted, respectively at each switch over, with the term ΔI/2, under control by the frequency loop, the two control loops will not interact and the circuit can operate as a constant-frequency voltage controller, because of the tripping thresholds of $I_M$ and $I_m$ of the comparator being adjusted differentially with respect to the average value.

Figure 4 illustrates a block diagram of the improved circuit according to the invention operating on the principle just explained. In the Figure, the closed loop circuit for regulating the mean current (comprising a sensor 1', inductor L', diode 3', hysteresis comparator 4', transistor 5', error amplifier 6', capacitor 7', and resistors 8', which operate similarly to the corresponding components of the circuit of Figure 1) has been added a closed loop circuit for regulating the frequency such as not to interfere with the first loop. That closed frequency-regulating loop includes a phase comparator 9, which compares the signal at the base of the transistor 5' to a synchronization signal, a block 10 which detects the sign of the output signal from the comparator 4' and multiplies it by the output signal from the phase comparator 9, and an adder block 11 which adds the signal from the sensor 1' to the signal from the block 10 and feeds the hysteresis comparator 4'.

In practice, therefore, by measuring the phase displacement, between the signal from the hysteresis comparator 4' and a suitable external signal Vsy, it becomes possible to obtain, at the output of the phase comparator 9, a signal having such an amplitude as to supply the desired frequency in accordance with the above formulae, whilst the block 10 multiplies said signal by the sign of the hysteresis comparator 4' output voltage, thereby said signal is alternately added to and subtracted from the current supplied by the sensor 1'. Thus, regulation of the frequency is achieved without changing, within one period length, the current passed to the input of the average current regulating stage, the operation whereof is, hence, unaffected by the frequency regulating stage.

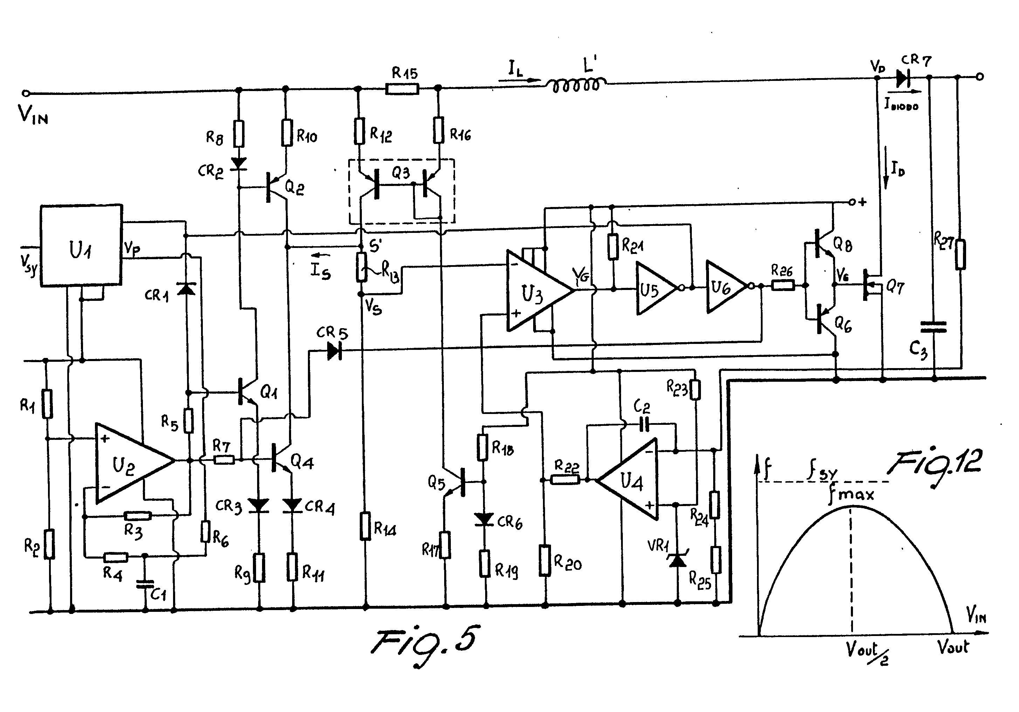

Shown in Figure 5 is a complete circuit diagram of the voltage control device according to the invention, wherein the resistors R12, R15, R16, R17, R18, and R19, diode CR6, and transistors Q3 and Q5 make up the block 1'; the diode CR7 corresponds to the diode 3' of Figure 4; the comparator U3 and resistor R21 make up the block 4' of the hysteresis comparator; the resistor R26 and transistors Q6—Q8 correspond to the transistor 5' of Figure 4; the resistors R20, R22, R23, Zener diode VR1, capacitor C2, and operational amplifier U4 form the block 6'; the capacitor C3 correspond to 7' of Figure 4; resistors R27 and R24, R25 correspond to resistors 8' of Figure 4; the resistor R6, capacitor C1 and PLL (Phase Locked Loop) U1 make up the block 9; the resistors R1—R5, R7—R11, diodes CR1—CR5, transistors Q1, Q2 and Q4, and inverters U5 and U6 make up the block 10; and the resistors R13 and R14 form the block 11.

The frequency control stage of the above circuit operates as follows. It is first assumed that the transistor Q7 is saturated, in which case the current through the inductor L' would grow linearly according to the relationship

$$I_L = I_{LO} + \frac{V_{in} \times t}{L}$$

where $I_{LO}$ is the initial current value in the inductance L at the time whereat Q7 is turned on (saturated).

In that condition, the voltage $V_G$ is high, so that the output of U6 is high and that of U5 at a low. Consequently, through the diode CR1, the transistor Q1 is turned off, as is Q2, which will supply no current to the resistor R13. The output of U6 being at a high, the diode CR5 will apply no blocking on the base of Q4 which, being driven by the output voltage of U2, has an emitter current which is proportional to that voltage (base resistance, R7, and R5 produce a very low drop, having the sole function of uncoupling the bases of the two transistors) owing to the feedback resistor R11 of the emitter.

Given that the collector current of Q4 is virtually equal to that of the emitter (neglecting base current), a current flows through the collector of Q4 which is subtracted, at the knot S', from that supplied from the collector (left-hand side) of Q3. Accordingly, voltage at the point S' is given by the product of total resistance $R_{TOT}=R13+R14$ by the total current $I_{TOT}=I_{c3}-\Delta I/2$. And since the current $I_{c3}$ is proportional to the current $I_L$ through the inductor, we obtain

$$V_{S'}=(I_{LO}+\frac{V_{in}\times t}{L})\times R_{TOT}-\frac{\Delta I}{2}\times R_{TOT}$$

having the waveform shown in Figure 3 at the first period portion $\Delta t_1$.

When, on the contrary, Q7 is turned off ($\Delta t_2$), the current $I_L$ through the inductor L' decreases linearly in accordance with the following law,

$$I_L=I_{LO'}+\frac{V_{in}-V_o}{L}\times t$$

In such conditions, $V_G$ is low, the output of U6 is also low, the output of U5 high, and hence, through the diode CR5, it is the transistor Q4 which is off, whereas Q1, being uncoupled from the output of U5 through CR1, is free to conduct an emitter current which is directly proportional to the output voltage of U2 and inversely proportional to the resistance of R9; since R9 and R11 have been selected to have the same value, the emitter current of Q1 in its conductive state is equal to the current of Q4 while the latter is conductive, at the first period portion $\Delta t_1$.

Q1 being conductive, also conductive is Q2 which has a collector current (set to be equal to the collector current of Q1) passed to the knot S' to add itself to the current from the collector of Q3 (left-hand side). The final waveform is that shown in Figure 3 at the second period portion $\Delta t_2$.

In conclusion, this circuit allows the adding and subtracting, alternately during $\Delta t_1$ and $\Delta t_2$ respectively, a current supplement which creates hysteresis at the comparator U3.

The frequency being, as mentioned, inversely proportional to that hysteresis, by regulating that hysteresis the frequency may be regulated.

The hysteresis current $\Delta I/2$, as algebraically added in the knot S', is proportional, as mentioned, to the output voltage of U2, i.e.

$$V_1=-V_{Pm}\times\frac{R3}{R4}+V_{Rf}\times\frac{R3+R4}{R4}$$

where:

$V_{Rf}$ is the fixed reference voltage set by R1 and R2; and

$V_{Pm}$ is the average value of the voltage $V_P$ as filtered by R6 and C1.

The synchronization frequency being slightly higher than the peak free-running frequency of the circuit, from the increase of the frequency error $f=f_{sy}-f_{boost}$, it may be concluded that the boosting frequency has decreased; as a result, the voltage $V_{Pm}$ increases, voltage $V_1$ decreases, the hysteresis current $\Delta I/2$ decreases, and frequency is forced to increase.

This last occurrence is important: synchronization can only take place at a frequency which is higher than the boost free-running highest frequency (see Figure 12). In fact, if the synchronization frequency is selected to be lower than the peak frequency ($f_{max}$), with $V_{in}\simeq V_o/2$, the frequency error would increase, causing $V_{Pm}$ to increase, $V_1$ and $\Delta I$ to decrease, so that the switching rate would be again forced to increase instead of decreasing; in essence, a positive rather than a negative—feedback loop would be the net result.

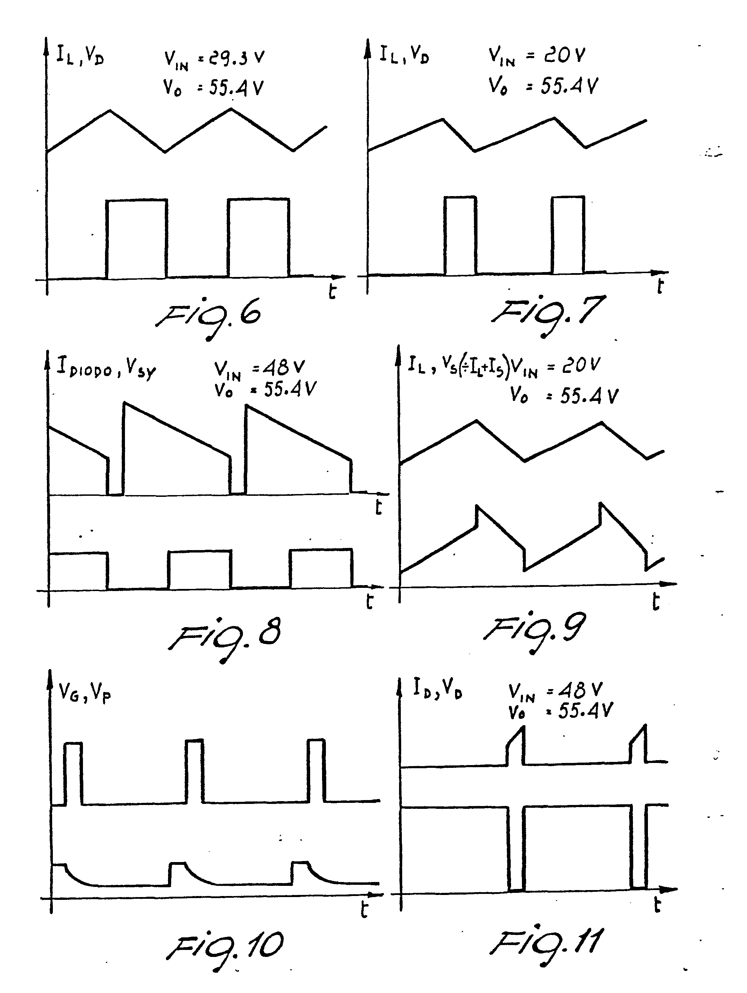

Figure 5 shows the main circuit points wherefrom there are derived the electrical signals the behaviour with time whereof is illustrated, for different values of the input voltage, in Figures 6—11 (not to a common scale).

It will be appreciated from the foregoing description that the electronic voltage control device of this invention fully achieves its objects. In particular, a circuit is provided, whereby it becomes possible to control, besides the output voltage, also the switching rate, while retaining a transfer function of the first order, thanks to the frequency control closed loop and average current control closed loop not interacting with each other and operating independently of each other.

Advantageous is also the utilization of commercially readily available components, which enables the cost of the inventive device to be kept within acceptable limits.

The invention as described is susceptible of many modifications and variations, without departing from the scope of the instant inventive concept.

Furthermore, all of the details may be replaced with other technically equivalent elements.

**Claims**

1. An electronic voltage control device, comprising a load average current controlling stage including a current sensor (1', Q3, Q5, R12, R15—R19, CR6), an inductor (L') and a hysteresis comparator (4; U3) arranged downstream of said current sensor and receiving at one input thereof a signal from an error amplifier (6'; U4), as well as an active switch-over element (5', Q6—Q8) located downstream of and being controlled by said hysteresis comparator (4', U3), a control stage (9—11; U1, U2, CR1—CR5, Q1, Q2, Q4, U5, U6) controlling the switch-over rate of said active element, and an output filter (7', 8'; C3, R24, R25, R27), characterized in that said control stage comprises a phase comparator (9; U1, U2) receiving at the inputs thereof a synchronization signal (Vsy) and the output signal ($V_G$) from said hysteresis comparator (4', U3), means (10; CR1—CR5, Q1, Q2, Q4, U5, U6) for multiplying the output signal of said phase comparator by a signal corresponding to the sign of said output signal of said hysteresis comparator and generating alternatively a positive and a negative current of equal amplitude according to said sign, and adder means (11; R13, R14) receiving at the inputs thereof a signal from said current sensor and said alternatively positive and negative currents, the output of said adder means being connected with another input of said hysteresis comparator.

2. An electronic device according to claim 1, characterized in that said means for multiplying (10) comprise first and second diodes (CR1, CR5) interposed between the output of said hysteresis comparator (U3) and a respective active element (Q1—Q2, Q4) in such a way as to alternatively switch on one of said respective active elements and switch off the other according to said sign.

3. An electronic device according to the preceding claims, characterized in that it comprises first and second inverters (U5, U6) cascade connected downstream of said hysteresis comparator (U3), said first and second diodes (CR1, CR5) being connected with the anode thereof to the respective active element (Q1—Q2, Q4), the cathode of the first diode (CR1) being connected to the output of the first inverter (U5) and the cathode of the second diode (CR5) being connected to the output of the second inverter (U6), the active element (Q1—Q2) connected to the first diode (CR1) being arranged so as to supply a current to the adder means, when switched on, while the active element (Q4) connected to the second diode (CR5) being arranged so as to subtract an equal amplitude current from said adder means when switched on.

4. An electronic device according to the preceding claims, characterized in that said phase comparator comprises a phase locked loop (U1) and an operational amplifier (U2) connected downstream of said phase locked loop.

## Patentansprüche

1. Elektronischer Spannungsregler, mit einer den Durchschnittslaststrom-Einstellstufe umfassend einen Stromsensor (1', Q3, Q5, R12, R15—R19, CR6), eine Drossel (L') und eine Hysteresekomparator (4; U3), der hinter dem Stromsensor angeordnet ist und an einem Eingang ein Signal von einem Fehlerverstärker (6'; U4) erhält, sowie ein aktives Umschaltelement (5', Q6—Q8), das hinter dem Hysteresekomparator (4', U3) angeordnet ist und von diesem gesteuert wird, einer Steuerstufe (9—11; U1, U2, CR1—CR5, Q1, Q2, Q4, U5, U6), welche die Umschaltgeschwindigkeit des aktiven Umschaltelements steuert, und einem Ausgangsfilter (7', 8'; C3, R24, R25, R27), dadurch gekennzeichnet, daß die Steuerstufe einen Phasenkomparator (9; U1, U2), welcher an den Eingängen ein Taktsignal (Vsy) und das Ausgangssignal ($V_G$) vom Hysteresekomparator (4', U3) erhält, eine Multipliziereinrichtung (10; CR1—CR5, Q1, Q2, Q4, U5, U6) zum Multiplizieren des Ausgangssignals des Phasenkomparators mit einem dem Vorzeichen des Ausgangssignals des Hysteresekomparators entsprechenden Signal und zur Erzeugung alternativ eines positiven und negativen Stroms gleicher Amplitude gemäß diesen Vorzeichen und eine Addiereinrichtung (11; R13, R14), welche an den Eingängen ein Signal vom Stromsensor und die genannten alternativ positiven und negativen Ströme empfängt, wobei der Ausgang der Addiereinrichtung an einen anderen Eingang des Hysteresekomparators angeschlossen ist.

2. Spannungsregler nach Anspruch 1, dadurch gekennzeichnet, daß die Multipliziereinrichtung (10) aus einer ersten und zweiten Diode (CR1, CR5) besteht, die zwischen dem Ausgang des Hysteresekomparators (U3) und je einem aktiven Umschaltelement (Q1—Q2, Q4) geschaltet ist, so daß abwechselnd eines der aktiven Umschaltelemente ein und das andere entsprechend dem Vorzeichen ausgeschaltet wird.

3. Spannungsregler nach den vorhergehenden Ansprüchen, dadurch gekennzeichnet, daß er einen ersten und zweiten Inverter (U5, U6) aufweist, die in Kaskadenschaltung hinter dem Hysteresekomparator (U3) vorgesehen sind, wobei die erste und zweite Diode (CR1, CR5) mit ihrer Anode an das jeweilige aktive Umschaltelement (Q1—Q2, Q4) angeschlossen sind, die Kathode der ersten Diode (CR1) mit dem Ausgang des ersten Inverters (U5) und die Kathode der zweiten Diode (CR5) mit dem Ausgang des zweiten Inverters (U6) verbunden ist, das an die erste Diode (CR1) angeschlossene aktive Umschaltelement (Q1—Q2) derart geschaltet ist, daß es, wenn eingeschaltet, einen Strom an die Addiereinrichtungen liefert, wogegen das an die zweite Diode (CR5) angeschlossene aktive Umschaltelement (Q4) derart geschaltet ist, daß es, wenn eingeschaltet, einen Strom gleicher Amplitude von den Addiereinrichtungen substrahiert.

4. Spannungsregler nach den vorhergehenden Ansprüchen, dadurch gekennzeichnet, daß der Phasenkomparator eine phasenstarre Schleife (U1) und einen hinter der phasenstarren Schleife angeschlossenen Operationsverstärker (U2) aufweist.

## Revendications

1. Dispositif électronique de commande de tension, comportant un étage de commande du courant de charge moyen qui comprend un détecteur de courant (1', Q3, Q5, R12, R15—R19, CR6), une inductance (L') et un comparateur incrémental (4; U3) placé en aval dudit détecteur de courant et recevant à une de ses entrées un signal en provenance d'un amplificateur d'erreur (6', U4), ainsi qu'un commutateur actif de pontage (5', Q6—Q8) placé en aval dudit comparateur (4'; U3) et commandé par lui, un étage de commande (9—11; U1, U2, CR1—CR5, Q1, Q2, Q4, U5, U6) commandant la fréquence de commutation dudit élément actif, et un filtre de sortie (7', 8'; C3, R24, R25, R27), caractérisé en ce que ledit étage de commande comprend un comparateur de phase (9; U1, U2) qui reçoit sur ses entrées un signal de synchronisation (Vsy) et le signal de sortie ($V_G$) dudit comparateur incrémental (4', U3), des moyens (10; CR1—CR5, Q1, Q2, Q4, U5, U6) pour multiplier le signal de sortie de ce comparateur de phase par un signal qui correspond au signe du signal de sortie dudit comparateur incrémental et qui fournit alternativement, selon ce signe, un courant positif et un courant négatif de même amplitude, un additionneur (11; R13, R14) qui reçoit à ses entrées un signal en provenance dudit détecteur de courant et les dits courants alternativement positifs et négatifs, la sortie dudit additionneur étant connectée à une autre entrée dudit comparateur incrémental.

2. Dispositif électronique selon la revendication 1, caractérisé en ce que lesdits moyens pour multiplier (10) comprennent une première et une seconde diodes (CR1, CR5) interposées entre la sortie dudit comparateur incrémental (U3) et un élément actif respectif (Q1—Q2, Q4) de manière à alternativement activer l'un desdits éléments actifs respectifs et désactiver l'autre selon ledit signe.

3. Dispositif électronique selon les revendications précédentes, caractérisé en ce qu'il comporte un premier et un second inverseurs (U5, U6) connectés en cascade en aval dudit comparateur incrémental (U3), lesdites première et seconde diodes (CR1, CR5) ayant leur anode connectée à l'élément actif respectif (Q1—Q2, Q4), la cathode de la première diode (CR1) étant connectée à la sortie du premier inverseur (U5) et la cathode de la seconde diode (CR5) étant connectée à la sortie du second inverseur (U6), l'élément actif (Q1—Q2) connecté à la première diode (CR1) étant agencé pour fournir un courant à l'additionneur, lorsqu'il est activé, tandis que l'élément actif (Q4) qui est connecté à la seconde diode (CR5) est agencé pour soustraire un courant de même amplitude dudit additionneur, lorsqu'il est activé.

4. Dispositif électronique selon les revendications précédentes, caractérisé en ce que ledit comparateur de phase comprend une boucle de phase (U1) et un amplificateur opérationnel (U2) placé en aval de ladite boucle de phase.

0 090 237

Fig.1

Fig.2

Fig.3

Fig.4

1

Fig.5

Fig.12

0 090 237

Fig.6

Fig.7

Fig.8

Fig.9

Fig.10

Fig.11